Europäisches Patentamt

(19) **European Patent Office**

Office européen des brevets

(11) Publication number: **0 016 984**
**B1**

(12) # EUROPEAN PATENT SPECIFICATION

(45) Date of publication of patent specification: **27.06.84**

(21) Application number: **80101078.6**

(22) Date of filing: **04.03.80**

(51) Int. Cl.³: **H 05 K 3/30, H 05 K 13/04, H 01 G 1/035**

(54) Method of mounting at least one electronic component. -

(30) Priority: **09.03.79 JP 28101/79**

(43) Date of publication of application:
**15.10.80 Bulletin 80/21**

(45) Publication of the grant of the patent:
**27.06.84 Bulletin 84/26**

(84) Designated Contracting States:
**DE FR GB NL**

(56) References cited:
**DE - A - 2 904 649**

**JOURNAL OF ELECTRONIC ENGINEERING, Vol. 16, No. 150, June 1979 M. OHSAWA " UHIC System Makes Sophisticated Products Possible" pages 50 to 53**
**NATIONAL TECHNICAL REPORT Vol. 24, no 1, February 1978 pages 120 to 126**

(73) Proprietor: Matsushita Electric Industrial Co., Ltd.
1006, Oaza Kadoma
Kadoma-shi Osaka-fu, 571 (JP)

(72) Inventor: Ikeda, Junji
29, Koyodai, Ikoma-shi
Nara-Ken (JP)
Inventor: Hochin, Ryuzo
Shoki-ryo 25-3, Mido-cho
Kadoma-shi Osaka (JP)
Inventor: Wakahata, Tamotsu
13-3, Aoyama 3-chome
Katano-shi Osaka (JP)

(74) Representative: Stach, Harald, Dr. Dipl.-Chem. et al,
Adenauerallee 30
D-2000 Hamburg 1 (DE)

## Description

The invention relates to a method for mounting at least one electronic component on a printed circuit board, comprising the steps of attaching the electronic component to the circuit board by a curable adhesive, curing the adhesive to rigidly bond the electronic component to the circuit boad, and soldering the resulting assembly.

Electronic components, such as chip resistors and chip capacitors are in the prior art attached to printed circuit boards of phenol-, epoxy- or polyimide resin or the like by applying to the electronic component or to a blank portion of the soldering pattern on the circuit board a small amount of an adhesive, joining the electronic component and the circuit board and passing the assembly through a heating furnace to cure the adhesive and provide a joint resistant to the force and heat to be applied thereto during soldering, and finally dipping the assembly in a molten solder bath for soldering. This method involves problems in the heat resistance and strength of the joint during soldering and is of very low productivity due to the required curing time.

It is also known to attach electronic components to a printed circuit board by applying pasty solder to the pattern bearing side of the circuit board, placing the electronic component on the circuit board in contact with the solder, heating the assembly to a high temperature, and allowing the assembly to stand for spontaneous solidification of the solder. Although this method enables the electronic components to be attached more rapidly without the necessity of using an adhesive, the electronic component is liable to move while the pasty solder is in molten state, so that it cannot be mounted with accuracy and it is difficult to form a uniform solder layer. A thin solder layer will not have sufficient joint strength, whereas a thick solder layer involves the risk of causing short-circuiting between adjacent conductor portions.

Since the known ultraviolet-curing resins can be produced by inexpensive production facilities and can contribute to the rationalisation of production, there have been executed studies on the practical use of such resins in various fields (National Technical Report, volume 24, February 1978, pages 120 to 126).

With reference to earlier applications GB—A—2 014 791 and DE—A—2 904 649 the applicant has voluntarily limited the scope of the present application by submitting a separate set of claims for the United Kingdom and the Federal Republic of Germany.

It is the main object of the invention to provide a method for mounting at least one electronic component on a printed circuit board as defined in the preamble of claim 1, which avoids the former drawbacks and enables a rapid and reliable mounting of the electroinc components with high accuracy.

The method defined in the preamble of claim 1 is characterized by:

using an adhesive curable by ultraviolet-initiated chain-like curing reaction,
applying the adhesive so as to form an excess portion extending outwardly from between the electronic component and the circuit board, and
irradiating the excess portion of the adhesive with ultraviolet rays from that side of the circuit board to which the electronic component adheres to cure the excess portion and thereafter the other portion of the adhesive by chain reaction.

With the method according to the invention the electronic components are temporarily held to the circuit board by the adhesive and subsequently rigidly attached thereto by curing the adhesive with ultraviolet rays so that the electronic components are reliably held with high accuracy in a fixed position during soldering. The electronic components can be mounted to the circuit boad very efficiently and with high accuracy, since the adhesive can be cured with ultraviolet rays without being thermally affected by heating that could impair the performance of the components. The circuit board having the electronic components attached thereto can be dipped in the known manner into a solder bath, whereby there can be produced a circuit with improved accuracy and reliability.

Whereas the portion of the adhesive position between the electronic component and the circuit board will not be exposed directly to irradiation and therefore according to the earlier methods would take a relatively long curing time, the method according to the invention provides a rapid and thorough curing of the adhesive, enabling to reduce the number of steps required for the overall process and much quicker and more economic production.

When desired, the adhesive conjointly with the ultraviolet irradiation can be heated to a moderate temperature not causing thermal degradation of the electronic components.

The preferred embodiment of the invention will be described below in detail with reference to the accompanying drawings, in which:

Figure 1 to Figure 4 are sectional views showing the step of mounting electronic components on a printed circuit board according to the method of this invention;

Figure 5 is a diagram showing an apparatus for curing the adhesive;

Figure 6 is a perspective view showing how the electronic component is attached to the board; and

Figure 7 and 8 are a perspective view and a sectional view, respectively, showing the component placed on a layer of adhesives on the board with excess portions of adhesive adjoining the component.

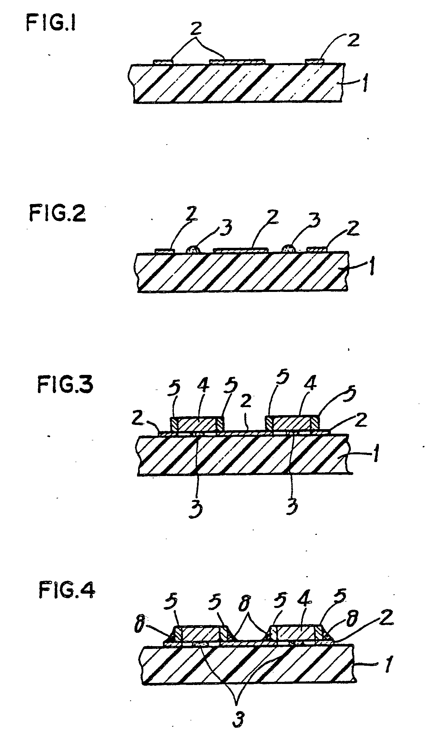

Figure 1 is a sectional view showing a printed circuit board 1 useful in this invention. Conductor portions 2 made of copper foil provide on the board 1 a pattern for electric wiring. According to the invention, adhesive 3 is applied to predetermined portions of the board 1 between the copper foil conductor portions 2 and 2 as seen in Figure 2.

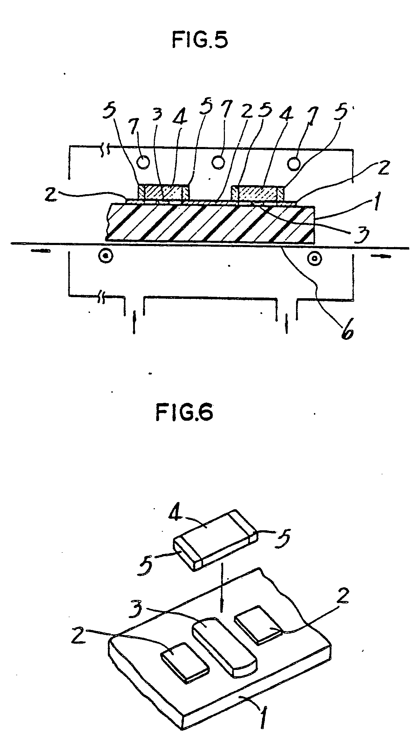

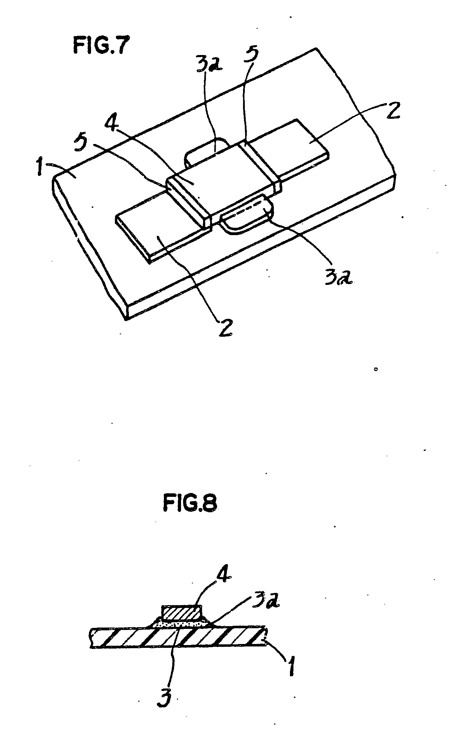

The adhesive is applied by screen printing, stamping with an applicator, coating with a dispenser or like method. Subsequently electronic components 4 having silver, palladium or like electrodes 5 are placed on the adhesive portions on the board 1 with the electrodes 5 in contact with the conductor portions 2. Thus the components 4 are temporarily attached to the board 1 by the tackiness of the adhesive 3 as shown in Figure 3. The component 4 thus installed in place is best shown in Figures 7 and 8, in which it is seen that the adhesive on the board 1 is forced out beyond the side edges of the component 4 to provide excess portions 3a. The component 4 can be attached to the board with the adhesive more effectively when the excess portions 3a are so formed that the side faces of the component 4 are partly in contact with the excess portions 3a. The board 1 having the components 4 thus temporarily attached thereto by the tackiness of the adhesive 3 is then transported on a conveyor 6 as shown in Figure 5. During transport on the conveyor 6, the board 1 is irradiated from above the components 4 with ultraviolet rays by an ultraviolet lamp 7, whereby the adhesive 3 is cured to effectively attach the components 4 in position. Thus the components 4 are rigidly attached to the board 1.

The above process will be described in greater detail. First, to temporarily attach the component to the board, a substantial amount of adhesive is applied to the board so that the adhesive adheres also to part of the side faces of the component. This can be done by forming a thick layer of adhesive over the same width as the component and pressing the component against the adhesive layer to partly force out the adhesive, or by forming an adhesive layer of larger width then the component before the installation of the component. When the board is irradiated with ultraviolet rays for curing, the reaction is initiated first at the excess portions 3a which are exposed to the rays and is thereafter effected progressively toward the remaining portion beneath the component in a chain-like manner, whereby the adhesive can be wholly cured.

The resulting assembly is thereafter dipped in a usual molten solder bath to join the electrodes 5 of the components 4 to the conductor portions 2 on the board 1 with solder 8 as seen in Figure 4.

The printed circuit board 1 is made of an insulating material, such as polyimide film, epoxy film having glass cloth incorporated therein, polyester film or laminated phenol sheet. The adhesive 3 comprises a material which is curable by ultraviolet irradiation. An example of useful adhesive compositions comprises an unsaturated polyester resin as the main component, benzoin butyl ether or the like as an ultraviolet sensitizer acting as a curing catalyst and trialkyl or triallyl phosphite or the like as a stabilizer. Another useful example comprises a monomer, oligomer or polymer serving as the main component and prepared by reacting an epoxy compound with acrylic or methacrylic acid in the presence of a tertiary amine, and an ultraviolet sensitizer such as benzoin or benzophenone compound. Another example is a composition comprising an addition product of olefin and thiol serving as the main component and benzophenone, fluorenone or like carbonyl compound serving as an ultraviolet sensitizer. Another example is a composition comprising bisphenol A-diglycidyl ether, aliphatic ether epoxide or like epoxy resin, and an allyldiazonium salt of complex halide which forms a Lewis acid when subjected to photodecomposition. The adhesives useful in this invention are highly reactive, such that when the excess adhesive portion 3a adjoining the side edge of the component 4 is irradiated with ultraviolet rays from above the board 1, the portion starts to undergo curing reaction, which subsequently proceeds over the remaining portion of the adhesive in a chain-like fashion to wholly cure the adhesive. The conditions under which the board is irradiated with ultraviolet rays are dependent on the ultraviolet activity and curing properties of the adhesive. With the present embodiment, the assembly was irradiated with ultraviolet rays at an intensity of 80 w/cm over a width of 150 mm while being transported at a speed of 3 m/min. The time required for completely curing the adhesive was as short as 3 seconds, whereas the conventional heating method takes 10 minutes for completely attaching the component in place. Thus the present method achieved a remarkably improved work efficiency. Therefore, the component attaching step according to the invention can be incorporated into a mass-production process without necessitating a very large heating furnance or like apparatus as conventionally used.

Although the present invention has been described above as embodied for chip components, the invention can be practiced in the same manner as above for discrete components having lead wires. While the adhesive is applied to the board before the installation of electronic components according to the above embodiment, the components are similarly mountable on the board by applying the adhesive to the bottom of the component, then setting the component on the board and pressing the component against the board to fit the component intimately to the board with the adhesive provided therebetween an excess portions extending outwardly therefrom. It is also possible to use an adhesive containing an ultraviolet sensitizer as curing catalyst conjointly with a thermally active catalyst so as to afford improved productivity and enhanced bond strength with both ultraviolet rays and heat. Useful thermally active catalysts include organic peroxides, azo compounds, etc.

The adhesive can be cured by ultraviolet irradiation or by both such irradiation and heating. In the latter case, the assembly can be heated, for example, simultaneously with or after ultraviolet irradiation, or in some other manner.

**Claims for the Contracting States: FR, NL**

1. A method for mounting at least one electronic component on a printed circuit board, comprising the steps of

   1. attaching the electronic component to the circuit board by a curable adhesive,
   2. curing the adhesive to rigidly bond the electronic component to the circuit board and
   3. soldering the resulting assembly,

characterized by:

   4. using an adhesive curable by ultraviolet initiated chain-like curing reaction,
   5. applying the adhesive so as to form an excess portion extending outwardly from between the electronic component and the circuit board, and
   6. irradiating the excess portion of the adhesive with ultraviolet rays from that side of the circuit board to which the electronic component adheres to cure the excess portion and thereafter the other portion of the adhesive by chain-reaction.

2. A method as claimed in claim 1, characterized in that the adhesive is cured by both ultraviolet irradiation and heating.

3. A method as claimed in claim 1 or 2, characterized in that an amount of the adhesive is applied to the board before attaching the component thereto so that the adhesive adheres to part of a side face of the component under the pressure applied for temporarily attaching the component to the board.

4. A method as claimed in any of claims 1 to 3 characterized in that the excess portion is formed by applying an amount of the adhesive to the board before attaching the component thereto so that the adhesive is partially forced out from between the component and the board when the component is pressed against the board.

5. A method as claimed in any of claims 1 to 4, characterized in that the excess portion is formed by applying the adhesive to the board over a width larger than the width of the component before attaching the component to the board.

6. A method as claimed in any of claims 1 to 5, characterized in that the adhesive comprise an acrylic resin, unsaturated polyester resin, thiol-olefin resin or epoxy resin.

7. A method as claimed in any of the foregoing claims, characterized in that the adhesive has incorporated therein an ultraviolet sensitizer as a curing catalyst.

8. A method as claimed in any of the foregoing claims, characterized in that the adhesive contains an ultraviolet sensitizer and a thermally active catalyst as curing catalysts.

**Claims for the Contracting States: DE, GB**

1. A method for mounting at least one electronic component on a printed circuit board, comprising the steps of:

   1. attaching the electronic component to the circuit board by an ultraviolet-curable adhesive forming an excess portion extending outwardly from between the electronic component and the circuit board,
   2. curing the adhesive by ultraviolet irradiation to rigidly bond the electronic component to the circuit board and
   3. soldering the resulting assembly,

characterized by:

   4. using an adhesive curable by ultraviolet-initiated chain-reaction and
   5. irradiating the excess portion of the adhesive solely with ultraviolet rays from that side of the circuit board to which the electronic component adheres to cure the excess portion and thereafter the other portion of the adhesive by chain reaction.

2. A method as claimed in claim 1, characterized in that the adhesive is cured by both ultraviolet irradiation and heating.

3. A method as claimed in claim 1 or 2, characterized in that an amount of the adhesive is applied to the board before attaching the component thereto so that the adhesive adheres to part of a side face of the component under the pressure applied for temporarily attaching the component to the board.

4. A method as claimed in any of claims 1 to 3 characterized in tht the excess portion is formed by applying an amount of the adhesive to the board before attaching the component thereto so that the adhesive is partially forced out from between the component and the board when the component is pressed against the board.

5. A method as claimed in any of claims 1 to 4, characterized in that the excess portion is formed by applying the adhesive to the board over a width larger than the width of the component before attaching the component to the board.

6. A method as claimed in any of claims 1 to 5, characterized in that the adhesive comprises an acrylic resin, unsturated polyester resin, thiol-olefin resin or epoxy resin.

7. A method as claimed in any of the foregoing claims, characterized in that the adhesive has incorporated therein an ultraviolet sensitizer as a curing catalyst.

8. A method as claimed in any of the foregoing claims, characterized in that the adhesive contains an ultraviolet sensitizer and a thermally active catalyst as curing catalysts.

**Patentansprüche für die Vertragsstaaten: FR, NL**

1. Ein Verfahren zur Anbringung wenigstens eines elektronischen Bauteils auf einer gedruckten Schaltungsplatine, umfassend die Schritte:

   1. Anheften des elektronischen Bauteils an der Schaltungsplatine durch einen härtbaren Klebstoff,
   2. Aushärten des Klebstoffs zur starren Befestigung des elektronischen Bauteils an der Schaltungsplatine und
   3. Löten der entstandenen Anordnung,

gekennzeichnet durch:

   4. Verwendung eines durch ultraviolett-initiierte Kettenreaktion härtbaren Klebstoffs,
   5. Auftragen des Klebstoffs unter Bildung eines sich von zwischen dem elektrischen Bauteil und der Schaltungsplatine auswärts erstreckenden Überschußbereiches und
   6. Bestrahlung nur des Überschußbereichs des Klebstoffs mit Ultraviolettstrahlen von der Seite der Schaltungsplatine, an welcher das elektronische Bauteile befestigt ist, um den Überschußbereich und nachfolgend den anderen Bereich des Klebstoffs durch Kettenreaktion auszuhärten.

2. Ein Verfahren wie in Anspruch 1 beansprucht, dadurch gekennzeichnet, daß der Klebstoff durch Ultraviolett-Bestrahlung und Erwärmung ausgehärtet wird.

3. Ein Verfahren wie in Anspruch 1 oder 2 beansprucht, dadurch gekennzeichnet, daß auf die Schaltungsplatine vor dem Anheften des Bauteils daran eine Klebstoffmenge aufgetragen wird, so daß der Klebstoff unter dem zur zeitweisen Befestigung des Bauteils an der Schaltungsplatine angewandten Druck an einem Teil einer Seitenfläche des Bauteils haftet.

4. Ein Verfahren wie in irgendeinem der Ansprüche 1 bis 3 beansprucht, dadurch gekennzeichnet, daß der Überschußbereich durch Auftragen einer Portion des Klebstoffs auf die Schaltungsplatine vor dem Anheften des Bauteils daran gebildet wird, so daß der Klebstoff teilweise zwischen dem Bauteil und der Schaltungsplatine herausgetrieben wird, wenn das Bauteil gegen die Schaltungsplatine gepreßt wird.

5. Ein Verfahren wie in irgendeinem der Ansprüche 1 bis 4 beansprucht, dadurch gekennzeichnet, daß der Überschußbereich vor dem Anheften des Bauteils an der Schaltungsplatine durch Auftragen des Klebstoffes auf die Schaltungsplatine über eine größere Breite als die Breite des Bauteils gebildet wird.

6. Ein Verfahren wie in irgendeinem der Ansprüche 1 bis 5 beansprucht, dadurch gekennzeichnet, daß der Klebstoff ein Acrylharz, ein ungesättigtes Polyesterharz, ein Thiol-Olefinharz oder ein Epoxyharz umfaßt.

7. Ein Verfahren wie in irgendeinem der vorhergehenden Ansprüche beansprucht, dadurch gekennzeichnet, daß in dem Klebstoff ein Ultraviolett-Sensibilisator als Aushärtungs-Katalysator enthalten ist.

8. Ein Verfahren wie in irgendeinem der vorhergehenden Ansprüche beansprucht, dadurch gekennzeichnet, daß der Klebstoff einen Ultraviolett-Sensibilisator und einen thermisch aktiven Katalysator als Aushärtungs-Katalysator enthält.

**Patentansprüche für die Vertragsstaaten: DE, GB**

1. Ein Verfahren zur Anbringung wenigstens eines elektronischen Bauteils auf einer gedruckten Schaltungsplatine, umfassend die Schritte.

   1. Anheften des elektronischen Bauteils an der Schaltungsplatine durch eine ultraviolett-härtbaren Klebstoff unter Bildung eines sich von zwischen dem elektrischen Bauteil und der Schaltungsplatine auswärts erstreckenden Überschußbereiches,
   2. Aushärten des Klebstoffs durch Ultraviolett-Bestrahlung zur starren Befestigung des elektronischen Bauteils an der Schaltungsplatine und
   3. Löten der entstandenen Anordnung,

gekennzeichnet durch:

   4. Verwendung eines durch ultraviolett-initiierte Kettenreaktion härtbaren Klebstoffs und
   5. Bestrahlung nur des Überschußbereichs des Klebstoffs mit Ultraviolettstrahlen von der Seite der Schaltungsplatine, an welcher das elektronische Bauteil befestigt ist, um den Überschußbereich und nachfolgend den anderen Bereich des Klebstoffs durch Kettenreaktion auszuhärten.

2. Ein Verfahren wie in Anspruch 1 beansprucht, dadurch gekennzeichnet, daß der Klebstoff durch Ultraviolett-Bestralung und Erwärmung ausgehärtet wird.

3. Ein Verfahren wie in Anspruch 1 oder 2 beansprucht, dadurch gekennzeichnet, daß auf die Schaltungsplatine vor dem Anhaften des Bauteils daran eine Klebstoffmenge aufgetragen wird, so daß der Klebstoff unter dem zur zeitweisen Befestigung des Bauteils an der Schaltungsplatine angewandten Druck an einem Teil einer Seitenfläche des Bauteils haftet.

4. Ein Verfahren wie in irgendeinem der Ansprüche 1 bis 3 beansprucht, dadurch gekennzeichnet, daß der Überschußbereich durch Auftragen einer Portion des Klebstoffs auf die Schaltungsplatine vor dem Anheften des Bauteils daran gebildet wird, so daß der Klebstoff teilweise zwischen dem Bauteil und der Schaltungsplatine herausgetrieben wird, wenn das Bauteil gegen die Schaltungsplatine gepreßt wird.

5. Ein Verfahren wie in irgendeinem der Ansprüche 1 bis 4 beansprucht, dadurch gekennzeichnet, daß der Überschußbereich vor dem Anhaften des Bauteils an der Schaltungsplatine durch Auftragen des Klebstoffes auf die Schaltungsplatine über eine größere Breite als die Breite des Bauteils gebildet wird. .

6. Ein Verfahren wie in irgendeinem der Ansprüche 1 bis 5 beansprucht, dadurch gekennzeichnet, daß der Klebstoff ein Acrylharz, ein ungesättigtes Polyesterharz, ein Thiol-Olefinharz oder ein Epoxyharz umfaßt.

7. Ein Verfahren wie in irgendeinem der vorhergehenden Ansprüche beansprucht, dadurch gekennzeichnet, daß in dem Klebstoff ein Ultraviolett-Sensibilisator als Aushärtungs-Katalysator enthalten ist.

8. Ein Verfahren wie in irgendeinem der vorhergehenden Ansprüche beansprucht, dadurch gekennzeichnet, daß der Klebstoff einen Ultraviolett-Sensibilisator und einen thermisch aktiven Katalysator als Aushärtungs-Katalysator enthält.

**Revendications pour les états Contractants: FR, NL**

1. Procédé de montage d'au moins un composant électronique sur une plaquette de circuit imprimé, procédé comprenant les étapes de:

1) fixation du composant électronique sur la plaquette de circuit imprimé par une colle durcissable,
2) opération de durcissement de la colle pour fixer rigidement le composant électronique sur la plaquette de circuit imprimé, et
3) soudage du montage obtenu,

caractérisé en ce que:

4) on utilise un colle durcissable par une réaction en chaîne ultraviolet-démarrée de durcissement,
5) on applique la colle pour former une partie en excédent qui s'étend dans l'extérieur à partir d'entre le composant électronique et la plaquette de circuit, et
6) on irradie seulement la partie en excédent de la colle avec des rayons ultraviolets du ce côté de la plaquette de circuit sur lequel colle le composant électronique pour faire durcir la partie en excédent, puis l'autre partie de colle par la réaction en chaîne.

2. Procédé selon la revendication 1, caractérisé en ce que la colle est durcie par rayonnement ultraviolet et par échauffement.

3. Procédé selon la revendication 1 ou 2, caractérisé en ce qu'une quantité de colle est appliquée sur la plaquette avant la fixation du composant sur celle-ci pour que la colle adhère à une partie d'une surface latérale du composant sous la pression appliquée pour fixer temporairement le composant sur la plaquette.

4. Procédé selon l'une quelconque des revendications 1 à 3, caractérisé en ce que la partie en excédent est formée en appliquant une quantité de colle sur la plaquette avant d'y fixer le composant pour que la colle soit partiellement forcée en dehors d'entre le composant et la plaquette.

5. Procédé selon l'une quelconque des revendications 1 à 4, caractérisé en ce que la partie en excédent est formée en appliquant la colle sur la plaquette sur une largeur plus grande que la largeur du composant avant de fixer le composant sur la plaquette.

6. Procédé selon l'une quelconque des revendications 1 à 5, caractérisé en ce que la colle contient une résine acrylique, une résine de polyester non saturée, une résine thiol-oléfine ou une résine époxyde.

7. Procédé selon l'une quelconque des revendications précédentes, caractérisé en ce que la colle contient un agent de sensibilisation aux ultraviolets comme catalyseur de durcissement.

8. Procédé selon l'une quelconque des revendications précédentes, caractérisé en ce que la colle contient un agent de sensibilisation aux ultraviolets et un catalyseur thermo-actif comme catalyseurs de durcissement.

**Revendications pour les états Contractants: DE, GB**

1. Procédé de montage d'au moins un composant électronique sur une plaquette de circuit imprimé, procédé comprenant les étapes de:

1) fixation du composant électronique sur la plaquette de circuit imprimé par une colle durcissable par des ultraviolets, formant une partie en excédent qui s'étend dans l'extérieur à partir d'entre le composant électronique et la plaquette de circuit,

2) opération de durcissement de la colle par rayonnement ultraviolet pour fixer rigidement le composant électronique sur la plaquette de circuit, imprimé, et

3) soudage du montage obtenu,

caractérisé en ce que:

4) on utilise une colle durcissable par une réaction en chaîne ultraviolet-démarée de durcissement et

5) on irradie seulement la partie en exédent de la colle avec des rayons ultraviolets du ce côté de la plaquette de circuit sur lequel colle le composant électronique pour fiare durcier la partie en excédent, puis l'autre partie de colle par la réaction en chaîne.

2. Procédé selon la revendication 1, caractérisé en ce que la colle est durcie par rayonnement ultraviolet et par échauffement.

3. Procédé selon la revendication 1 ou 2, caractérisé en ce qu'une quantité de colle est appliquée sur la plaquette avant la fixation du composant sur celle-ci pour que la colle adhère à une partie d'uine surface latérale du composant sous la pression appliquée pour fixer temporairement le composant sur la plaquette.

4. Procédé selon l'une quelconque des revendicaticns 1 à 3, caractérisé en ce que la partie en excédent est formée en appliquant une quantité de colle sur la plaquette avant d'y fixer le composant pour que la colle soit partiellement forcée en dehors d'entre le composant et la plaquette.

5. Procédé selon l'une quelconque des revendications 1 à 4, caractérisé en ce que la partie en excédent est formée en appliquant la colle sur la plaquette sur une largeur plus grande que la largeur du composant avant de fixer le composant sur la plaquette.

6. Procédé selon l'une quelconque des revendications 1 à 5, caractérisé en ce que la colle contient une résine acrylique, une résine de polyester non saturée, une résine thiol-oléfine ou une résine époxyde.

7. Procédé selon l'une quelconque des revendications précédentes, caractérisé en ce que la colle contient un agent de sensibilisation aux ultraviolets comme catalyseur de durcissement.

8. Procédé selon l'une quelconque des revendications précédents, caractérisé en ce que la colle contient un agent de sensibilisation aux ultraviolets et un catalyseur thermo-actif comme catalyseurs de durcissement.

FIG.1

FIG.2

FIG.3

FIG.4

0016984

FIG.5

FIG.6

2

**FIG.7**

**FIG.8**